# EUROPÄISCHE PATENTANMELDUNG

(11) **EP 4 648 257 A1**
(43) Veröffentlichungstag der Anmeldung: **12.11.2025**
(21) Anmeldenummer: 25162137.1
(22) Anmeldetag: 06.03.2025
(51) Int. Cl.: H02J 9/06, H05K 7/14

(54) **USV-BAUGRUPPE, USV-BAUGRUPPEN-BAUSATZ, ELEKTRISCHE ANLAGE UND VERWENDUNG EINES AKKUMULATORS FÜR HANDWERKZEUGE IN EINER USV-BAUGRUPPE**

(30) Priorität: 08.05.2024 DE 102024113063
(71) Anmelder: Murrelektronik GmbH, 71570 Oppenweiler (DE)
(72) Erfinder: Aumüller, Jan, 71570 Oppenweiler (DE)
(74) Vertreter: Prinz & Partner mbB

(57) **Zusammenfassung**

Die Erfindung betrifft eine USV-Baugruppe (16), umfassend ein Gehäuse (26), eine USV-Elektronik (28), die im Gehäuse (26) angeordnet ist, einen Energiespeicher (30) und eine Aufnahme (32) für den Energiespeicher (30), die im oder am Gehäuse (26) angeordnet ist. Die Aufnahme (32) für den Energiespeicher (30) ist dazu ausgebildet, den Energiespeicher (30) lösbar im oder am Gehäuse (26) zu fixieren, sodass der Energiespeicher (30) entnehm- und wechselbar ist. Erfindungsgemäß ist vorgesehen, dass der Energiespeicher (30) dazu ausgebildet ist, in die Aufnahme (32) so eingesteckt zu werden oder an die Aufnahme (32) so angesteckt zu werden, dass eine elektrische Verbindung vom Energiespeicher (30) zur USV-Elektronik (28) gebildet ist.

Ferner betrifft die Erfindung einen USV-Baugruppen-Bausatz (44), eine elektrische Anlage (10) und eine Verwendung eines Akkus (34) für Handwerkzeuge in einer USV-Baugruppe (16).

## Beschreibung

Die Erfindung betrifft eine USV-Baugruppe, einen USV-Baugruppen-Bausatz, eine elektrische Anlage und eine Verwendung eines Akkumulators (kurz Akkus) für Handwerkzeuge in einer USV-Baugruppe. Insofern liegt die Erfindung grundsätzlich im Bereich der unterbrechungsfreien Stromversorgung (USV).

Viele aus dem Stand der Technik bekannte USV-Geräte und Puffermodule weisen elektrische Energiespeicher auf, beispielsweise Batterien und/oder Akkus, die fest in die jeweiligen Geräte integriert sind. Aus dieser Bauform heraus ergeben sich mehrere Probleme.

Zum einen unterliegt der Transport und die Entsorgung von Geräten mit derartigen Energiespeichern oft besonderen gesetzlichen Vorgaben und Richtlinien. So müssen in vielen Ländern beispielsweise Pakete, die Batterien und/oder Akkus enthalten, besonders gekennzeichnet werden.

Auch die sonstige Handhabung und Verwendung von Geräten mit Batterien und/oder Akkus ist in den meisten Ländern streng reglementiert, in Europa beispielsweise über die RICHTLINIE 2006/66/EG des Europäischen Parlaments und des Rates über Batterien und Akkumulatoren sowie Altbatterien und Altakkumulatoren.

Beholfen wird sich oft damit, dass Batterien und/oder Akkus von spezialisierten Firmen separat von den jeweiligen Einsatzgeräten verschickt und erst am Einbauort in das jeweilige Gerät integriert werden. Dieses zieht jedoch einen erhöhten Zeit- und Organisationsaufwand nach sich.

Ein weiterer Nachteil von USV-Geräten konventioneller Bauart ist, dass für einen Austausch eines veralteten oder defekten elektrischen Energiespeichers das jeweilige Gerät abgeschaltet und geöffnet werden muss. Dies kann im schlimmsten Falle sogar zu einem Anlagenstillstand führen.

Ferner können sowohl die Installation als auch der Austausch von fest verbauten Energiespeichern in der Regel nur von speziell geschultem Personal durchgeführt werden.

Die Aufgabe der Erfindung ist es daher, die aus dem Stand der Technik bekannten Nachteile zu beheben, indem ein technisch einfach aufgebautes und bedienerfreundliches System bereitgestellt wird.

Die Aufgabe wird erfindungsgemäß gelöst durch eine USV-Baugruppe, umfassend ein Gehäuse, eine USV-Elektronik, die im Gehäuse angeordnet ist, einen Energiespeicher und eine Aufnahme für den Energiespeicher, die im oder am Gehäuse angeordnet ist. Die Aufnahme für den Energiespeicher ist dazu ausgebildet, den Energiespeicher lösbar im oder am Gehäuse so zu fixieren, dass der Energiespeicher entnehm- und wechselbar ist. Erfindungsgemäß ist außerdem vorgesehen, dass der Energiespeicher dazu ausgebildet ist, so in die Aufnahme eingesteckt zu werden oder so an die Aufnahme angesteckt zu werden, dass eine elektrische Verbindung vom Energiespeicher zur USV-Elektronik gebildet ist.

Durch die Aufnahme wird die Möglichkeit geschaffen, den Energiespeicher technisch besonders einfach und schnell mit der USV-Elektronik zu verbinden, insbesondere ohne dass dazu das Gehäuse geöffnet werden muss oder Kabelverbindungen gelöst und/oder neu hergestellt werden müssen. Dies vereinfacht die Installation und den Austausch des Energiespeichers sowie die Wartung der USV-Baugruppe im Allgemeinen.

Insbesondere lässt sich der Energiespeicher werkzeuglos entnehmen und auswechseln. Die Aufnahme ist hierzu entsprechend ausgebildet. Es ist also nicht notwendig, dass Fachpersonal bzw. speziell geschultes Personal den Energiespeicher wechselt.

In einer Ausführungsvariante umfasst die USV-Baugruppe ein Fixiermittel, insbesondere zur mechanischen Fixierung der USV-Baugruppe an einer Steckplatte oder an einer Schiene, insbesondere Schaltschrankschiene bzw. Hutschiene.

Das Fixiermittel ermöglicht die Integration der USV-Baugruppe in übergeordnete Systeme.

Insbesondere kann das Fixiermittel dazu ausgebildet sein, die USV-Baugruppe in ein modular aufgebautes übergeordnetes System zu integrieren, beispielsweise in einen Schaltschrank.

Die USV-Baugruppe kann dann ein Modul des Systems bilden und die unterbrechungsfreie Stromversorgung weiterer Module, insbesondere weiterer im Schaltschrank angeordneter Komponenten, sicherstellen.

Vorzugsweise ist die USV-Baugruppe dazu ausgebildet und eingerichtet, die unterbrechungsfreie Stromversorgung der weiteren Module im Kleinspannungsbereich sicherzustellen. Insbesondere kann vorgesehen sein, dass die USV-Baugruppe dazu ausgebildet ist, bei Bedarf eine Wechselspannung kleiner oder gleich 50 V und/oder eine Gleichspannung kleiner oder gleich 120 V zum Betrieb der weiteren Module bereitzustellen.

In einer Ausführungsvariante ist das Fixiermittel dazu ausgebildet, in eine Schiene des Schaltschrankes einzugreifen und eine mechanische und/oder elektrische Verbindung der USV-Baugruppe zur Schiene zu schaffen.

Mit anderen Worten können also zwei mechanische Anbindungskomponenten vorgesehen sein, zum einen das Fixiermittel zur Anbindung der USV-Baugruppe in übergeordnete Systeme, und zum anderen die Aufnahme für den Energiespeicher, mittels welcher dieser an der USV-Baugruppe angebunden werden kann. Dadurch ergibt sich der Vorteil, dass die USV-Baugruppe besonders einfach und schnell am Einsatzort installiert, in Betrieb genommen und gewartet werden kann.

In einer weiteren Ausführungsvariante umfasst die USV-Baugruppe Anschlüsse zur direkten Anbindung von elektrischen Leitern. Beispielsweise können die Anschlüsse als Klemmen ausgebildet sein, insbesondere als Schraubklemmen oder als federkraftbasierte Klemmen.

Es können auch mehrere Anschlüsse vorgesehen sein, insbesondere Anschlüsse zur Anbindung an kleinspannungsführende Leitungen sowie Anschlüsse zur Anbindung an niederspannungsführende Leitungen.

Die Anschlüsse zur Anbindung an kleinspannungsführende Leitungen sind vorzugsweise dazu geeignet, an Leitungen angeschlossen zu werden, die Spannungen kleiner gleich 50 V Wechselspannung und/oder kleiner gleich 120 V Gleichspannung führen. Die Anschlüsse zur Anbindung an niederspannungsführende Leitungen sind vorzugsweise dazu geeignet, an Leitungen angeschlossen zu werden, die Spannungen größer 50 V Wechselspannung und/oder größer 120 V Gleichspannung führen.

Insofern kann die USV-Baugruppe eine Niederspannungs-Seite sowie eine Kleinspannungs-Seite aufweisen.

Über die Anbindungskomponenten kann zudem eine elektrische Verbindung hergestellt werden, sodass Energie aus dem Energiespeicher über die Aufnahme und das Fixiermittel an das übergeordnete System übertragen werden kann, um unter anderem Komponenten des übergeordneten Systems mit Energie zu versorgen, insbesondere beim Ausfall einer herkömmlichen Stromversorgung.

In einer bevorzugten Ausführungsform sind die Aufnahme für den Energiespeicher und das Fixiermittel auf unterschiedlichen Seiten des Gehäuses vorgesehen. Insbesondere können die Aufnahme und das Fixiermittel an entgegengesetzten Seiten des Gehäuses angeordnet sein.

Dadurch wird sichergestellt, dass der Energiespeicher und das Fixiermittel stets gut zugänglich sind. So kann die USV-Baugruppe beispielsweise an einer Gehäuseseite mit dem übergeordneten System verbunden werden und an der entgegengesetzten Gehäuseseite den Energiespeicher aufnehmen.

In einer weiteren Ausführungsvariante ist die Aufnahme dazu ausgebildet, den Energiespeicher derart lösbar im oder am Gehäuse zu fixieren, dass der Energiespeicher während eines laufenden Betriebes der USV-Baugruppe entfernt und/oder ausgetauscht werden kann.

Der Energiespeicher kann also ausgetauscht werden, ohne die USV-Baugruppe abschalten und/oder herunterfahren zu müssen. So wird sichergestellt, dass der Betrieb des Systems, in dem die USV-Baugruppe eine unterbrechungsfreie Stromversorgung gewährleistet, nicht oder nur möglichst wenig beeinträchtigt wird. Dies wird auch als "hot swapping" bzw. "hot plugging" bezeichnet.

In einer Variante der USV-Baugruppe weist die Aufnahme für den Energiespeicher zumindest eine Führung auf, die dazu dient, den Energiespeicher in eine Steckposition zu führen. Durch die Führung kann der Energiespeicher besonders schnell und einfach an die USV-Baugruppe angebunden werden.

Beispielsweise umfasst die Führung eine Führungsnut, in die ein Zapfen am Energiespeicher eingreift. In einer Ausführungsvariante kann die Führung den Energiespeicher mittels der Führungsnut in der Steckposition in zumindest zwei Raumrichtungen fixieren.

In diesem Zusammenhang ist denkbar, dass der Energiespeicher durch eine Bewegung entlang einer Oberfläche des Gehäuses, an der sich die Führungsnut befindet, in die Steckposition eingeschoben wird. Die Führungsnut ist beispielsweise so ausgebildet, dass sie dabei eine Bewegung des Energiespeichers sowohl quer zur Einschubrichtung als auch vom Gehäuse weg unterbindet, wodurch der Energiespeicher beim Anbinden in zwei Raumrichtungen geführt und in der Steckposition in den beiden Raumrichtungen fixiert wird. Der Energiespeicher kann also nur entlang der Einschubrichtung in die Aufnahme eingeschoben bzw. zur Einschubrichtung entgegengesetzt aus der Aufnahme entnommen werden.

Bei der Führung bzw. Führungsnut kann es sich beispielsweise um ein C-, L- oder T-förmiges Profil bzw. um eine entsprechend geformte Vertiefung handeln, die am Gehäuse oder dem Energiespeicher angeordnet ist. Selbstverständlich sind auch mehrere voneinander beabstandete, insbesondere parallel zueinander angeordnete, Nuten und/oder Profile denkbar.

Alternativ kann am Energiespeicher eine Führung bzw. Führungsnut vorgesehen sein, wobei die Aufnahme für den Energiespeicher einen entsprechenden Zapfen aufweist. Die zuvor beschriebenen Ausgestaltungen bzgl. der Führung bzw. Führungsnut der Aufnahme gelten in analoger Weise für die Führung bzw. Führungsnut des Energiespeichers.

In einer bevorzugten Ausführungsvariante ist die zumindest eine Führung der USV-Baugruppe nach dem Poka-Yoke-Prinzip ausgebildet, sodass der Energiespeicher nur in eine definierte Weise in die Aufnahme eingesetzt werden kann. Dadurch ist die Installation und/oder der Austausch des Energiespeichers besonders einfach und fehlerunanfällig. Im Idealfall ist für diese Arbeiten kein speziell geschultes Personal notwendig.

Ferner kann vorgesehen sein, dass die Aufnahme und/oder der Energiespeicher ein Arretierungselement umfasst, das dazu ausgebildet ist, den Energiespeicher in der Steckposition lösbar zu arretieren. Es ist auch denkbar, dass sowohl die Aufnahme als auch der Energiespeicher zueinander korrespondierende Arretierungselemente umfassen. Mittels des Arretierungselementes bzw. der Arretierungselemente kann der Energiespeicher in der Steckposition gegen ein unbeabsichtigtes Herausfallen bzw. Herausrutschen gesichert werden.

In Zusammenhang mit der Führungsnut, insbesondere C-, L- oder T-förmigen Profilen bzw. Vertiefungen, welche den Energiespeicher in der Steckposition in einer ersten und einer zweiten Raumrichtungen fixieren, kann vorgesehen sein, dass das Arretierungselement bzw. die Arretierungselemente den Energiespeicher in einer zur ersten und einer zweiten Raumrichtung senkrechten dritten Raumrichtung fixiert bzw. fixieren.

Es kann auch ein Betätigungselement vorgesehen sein, um das Arretierungselemente bzw. die Arretierungselemente zu lösen und den Energiespeicher beispielsweise entgegen der Einschubrichtung entlang der Führung aus der Steckposition zu entfernen.

In einer weiteren Ausführungsform ist der Energiespeicher eine Batterie, insbesondere ein Akku, der zur unmittelbaren Anbindung in oder an einem Handwerkzeug und zum Betrieb des Handwerkzeuges geeignet ist. Vereinfacht ausgedrückt können als Energiespeicher konventionelle Akkus, wie sie beispielsweise aus Akkuschraubern, Akku-Multifunktionswerkzeugen, akkubetriebenen Rasenmähern, kabellosen elektrischen Stichsägen oder kabellosen elektrischen Kettensägen bekannt sind, eingesetzt werden.

Wie sich gezeigt hat, weisen derartige Akkus ein ausreichendes Speicherpotenzial und geeignetes Ansprechverhalten zum Einsatz in der USV-Baugruppe auf.

Außerdem sind die Akkus von Handwerkzeugen typischerweise hinsichtlich ihrer Funktion und Sicherheit in der Entwicklung ausgereift, kostengünstig und schnell verfügbar. Beispielsweise können entsprechende Akkus einfach von einem nahegelegenen Baumarkt bezogen werden. Es muss für einen Austausch nicht erst auf eine Lieferung spezieller passender Ersatzteile gewartet werden.

In einer weiteren Variante der erfindungsgemäßen USV-Baugruppe ist die Aufnahme für den Energiespeicher ein austauschbarer Adapter, der dazu ausgebildet ist, den Energiespeicher elektrisch an die USV-Elektronik anzubinden und/oder mechanisch an das Gehäuse anzubinden.

Dadurch ist es möglich, unterschiedliche Akkus, insbesondere verschiedener Hersteller, in der USV-Baugruppe einzusetzen. Der Adapter kann beispielsweise an das Gehäuse der USV-Baugruppe lösbar angesteckt oder angeschraubt sein und so einfach ausgetauscht werden. In diesem Zusammenhang ist auch denkbar, dass der Adapter die zuvor erwähnte Führung und/oder Führungsnut bzw. ein Nutgegenstück, das in der Führungsnut geführt werden kann, wie einen Zapfen umfasst.

Alternativ kann auch vorgesehen sein, dass die Aufnahme für den Energiespeicher einen austauschbaren Adapter umfasst, der dazu ausgebildet ist, den Energiespeicher elektrisch an die USV-Elektronik anzubinden und/oder mechanisch an das Gehäuse anzubinden. Mit anderen Worten bildet der Adapter also einen Teil der Aufnahme. So muss zum Anbinden eines anderen Akkutyps nicht die gesamte Aufnahme ausgetauscht werden.

Die Aufgabe der Erfindung wird ferner gelöst durch einen USV-Baugruppen-Bausatz, umfassend eine erfindungsgemäße USV-Baugruppe und eine Mehrzahl unterschiedlicher austauschbarer Adapter, wobei jeder der unterschiedlichen austauschbaren Adapter dazu ausgebildet ist, jeweils einen Energiespeicher eines bestimmten Typs elektrisch an die USV-Elektronik anzubinden und/oder mechanisch an das Gehäuse anzubinden.

Die Vorteile, die zur USV-Baugruppe diskutiert wurden, gelten für den USV-Baugruppen-Bausatz in gleicher Weise.

Durch die unterschiedlichen austauschbaren Adapter ist der USV-Baugruppen-Bausatz flexibel einsetzbar. Wenn für einen auszutauschenden Akku, mit dem die USV-Baugruppe betrieben wird, gerade kein identischer Ersatzakku verfügbar ist, kann einfach der Adapter gewechselt werden und die USV-Baugruppe dann stattdessen mit einem Akku eines anderen bestimmten Typs betrieben werden.

Es ist auch denkbar, dass der USV-Gruppen-Bausatz mehrere Energiespeicher unterschiedlichen Typs umfasst. Die verschiedenen Energiespeicher können beispielsweise eine unterschiedliche Speicherkapazität und/oder unterschiedliche Lade- sowie Entladecharakteristiken aufweisen. Dadurch kann die vom USV-Baugruppen-Bausatz umfasste USV-Baugruppe speziell an die jeweiligen Einsatzbedürfnisse angepasst werden, indem ein für den Betrieb besonders geeigneter Energiespeicher aus der Mehrzahl der Energiespeicher ausgewählt wird.

Die Aufgabe der Erfindung wird außerdem gelöst durch eine elektrische Anlage, umfassend eine erfindungsgemäße USV-Baugruppe und eine Basis zur Aufnahme der USV-Baugruppe.

In einer Ausführungsform der elektrischen Anlage ist ein Schaltschrank vorgesehen. Der Schaltschrank kann selbstverständlich auch ein Bestandteil der elektrischen Anlage sein.

Denkbar ist auch, dass die Basis als Schaltschrankschiene bzw. Hutschiene ausgebildet und im Schaltschrank angeordnet ist.

Selbstverständlich gelten dabei die Vorteile, die zur USV-Baugruppe und zum USV-Baugruppen-Bausatz diskutiert wurden, für die elektrische Anlage in gleicher Weise.

In einer alternativen Ausführungsvariante der elektrischen Anlage ist die Basis als eine Steckplatte zur Aufnahme der USV-Baugruppe sowie weiterer steckbarer Module ausgebildet. Die einzelnen Module inklusive der USV-Baugruppe können insbesondere variabel, also an unterschiedlichen Stellen und/oder in unterschiedlichen Reihenfolgen, auf der Steckplatte angeordnet sein bzw. auf diese aufgesteckt werden. Mittels der Steckplatte können die einzelnen Module und insbesondere auch die USV-Baugruppe schnell und technisch einfach miteinander mechanisch sowie elektrisch zu einem funktionsfähigen System verbunden werden. Die USV-Baugruppe kann dann eine unterbrechungsfreie Stromversorgung für die übrigen Module, insbesondere die auf der Steckplatte angeordneten Module, bereitstellen.

Die Aufgabe der Erfindung wird ferner gelöst durch die Verwendung eines Akkus für Handwerkzeuge in einer USV-Baugruppe, insbesondere in einer erfindungsgemäßen USV-Baugruppe, als Energiespeicher zum Bereitstellen elektrischer Energie für eine unterbrechungsfreie Stromversorgung.

Auch für diese Verwendung gelten die Vorteile, die zur USV-Baugruppe, zum USV-Baugruppen-Bausatz und zur elektrischen Anlage diskutiert wurden in gleicher Weise.

Weitere Merkmale und Vorteile der Erfindung ergeben sich aus der nachfolgenden Beschreibung sowie aus den Zeichnungen, auf die Bezug genommen wird. In den Zeichnungen zeigen:
Fig. 1 eine schematische Darstellung einer erfindungsgemäßen elektrischen Anlage gemäß einer beispielhaften Ausführungsform;
Fig. 2 eine schematische Darstellung einer erfindungsgemäßen USV-Baugruppe einer ersten beispielhaften Ausführungsform; und
Fig. 3 eine schematische Darstellung eines Ausführungsbeispiels eines USV-Baugruppen-Bausatzes, umfassend eine erfindungsgemäße USV-Baugruppe einer zweiten beispielhaften Ausführungsform.

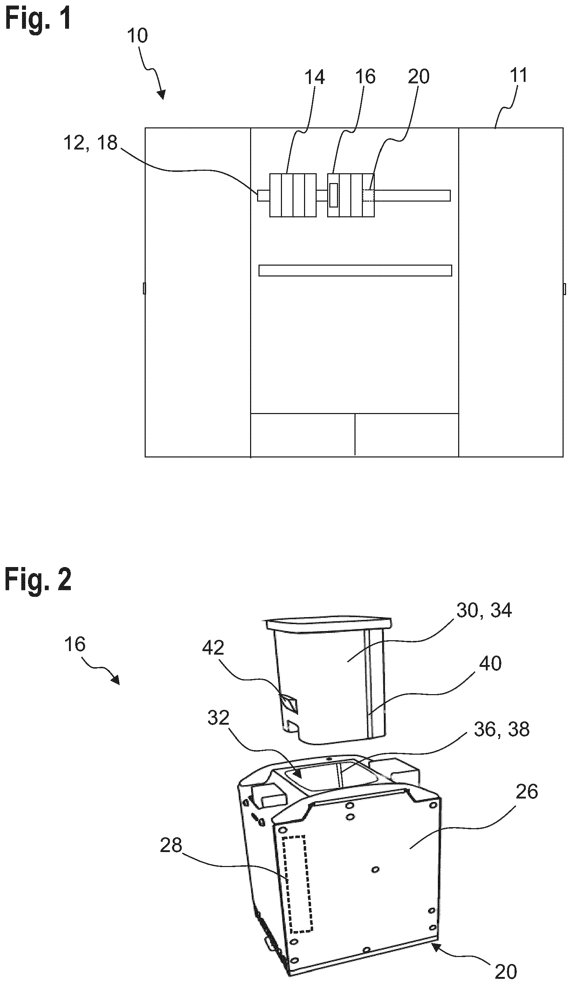

Fig. 1 zeigt schematisch ein Ausführungsbeispiel einer erfindungsgemäßen elektrischen Anlage 10. Die elektrische Anlage 10 umfasst einen Schaltschrank 11, eine Basis 12 und eine Mehrzahl an Modulen 14. Zumindest eines der Module 14 ist eine erfindungsgemäße USV-Baugruppe 16.

Die Basis 12 ist in der dargestellten Variante als Schaltschrankschiene 18 ausgebildet und innerhalb des Schaltschrankes 11 angeordnet.

Die Module 14, insbesondere die USV-Baugruppe 16, weisen jeweils zumindest ein Fixiermittel 20 auf, mittels dem sie mechanisch und elektrisch mit der Basis 12 verbunden sind.

Das Fixiermittel 20 kann beispielsweise als, insbesondere federvorgespannte(r), Steg, Haken oder Kralle oder als ein Hinterschnitt in einem Gehäuse des Moduls 14 ausgebildet sein und in die Schaltschrankschiene 18 eingreifen.

Eines oder mehrere der Module 14 können dazu ausgebildet sein, mit Spannungen im Kleinspannungsbereich und/oder im Niederspannungsbereich betrieben zu werden. Der Kleinspannungsbereich entspricht einer Wechselspannung kleiner oder gleich 50 V und/oder eine Gleichspannung kleiner oder gleich 120 V. Der Niederspannungsbereich entspricht einer Wechselspannung kleiner oder gleich 1000 V und/oder eine Gleichspannung kleiner oder gleich 1500 V.

Um eine unterbrechungsfreie Stromversorgung dieser Module 14 sicherzustellen, ist die USV-Baugruppe 16 dazu ausgebildet ist, bei Bedarf eine entsprechende Kleinspannung und/oder Niederspannung bereitzustellen.

Die hierfür nötigen elektrischen Verbindungen der USV-Baugruppe 16 zu den jeweiligen Modulen 14 sind im Ausführungsbeispiel durch elektrische Leiter bzw. Leitungen realisiert. An der USV-Baugruppe 16 können hierzu entsprechende Anschlüsse zum Anschließen der elektrischen Leiter bzw. Leitungen vorgesehen sein, insbesondere Klemmen.

Fig. 2 zeigt eine schematische dreidimensionale Darstellung einer erfindungsgemäßen USV-Baugruppe 16 einer ersten Ausführungsform, die für einen Einsatz in der in Fig. 1 gezeigten elektrischen Anlage 10 konzipiert ist.

Die USV-Baugruppe 16 umfasst ein Gehäuse 26 und eine USV-Elektronik 28, die sich innerhalb des Gehäuses 26 befindet.

Das Fixiermittel 20 ist in der dargestellten Ausführungsform an einer Seite der USV-Baugruppe 16 angeordnet (in Fig. 2 an der Unterseite) und wird bei der Installation der USV-Baugruppe 16 elektrisch sowie mechanisch an die Basis 12 (also die Schaltschrankschiene 18) angebunden.

Ferner weist die in Fig. 2 gezeigte USV-Baugruppe 16 einen Energiespeicher 30 und eine Aufnahme 32 für den Energiespeicher 30 auf.

Der Energiespeicher 30 ist ein Akku 34, der grundsätzlich zur unmittelbaren Anbindung in oder an einem Handwerkzeug und zum Betrieb des Handwerkzeuges geeignet ist. Beispielsweise kann es sich um einen Akku 34 eines konventionellen Akkuschraubers.

Insofern wird im Ausführungsbeispiel also ein Akku 34 für Handwerkzeuge in der USV-Baugruppe 16 als Energiespeicher 30 zum Bereitstellen elektrischer Energie für eine unterbrechungsfreie Stromversorgung verwendet.

Alternativ ist auch der Einsatz von Akkus 34 und/oder Batterien anderer, insbesondere im Hobby- und Privatbereich genutzter elektrischer Geräte denkbar, beispielsweise Akkus 34 bzw. Batterien von E-Bikes bzw. Pedelecs. Auch diese Speicher sind im Allgemeinen technisch weit entwickelt, betriebssicher und in breiter Masse verfügbar.

In der in Fig. 2 gezeigten USV-Baugruppe 16 ist die Aufnahme 32 eine Einschuböffnung im Gehäuse 26 und dazu ausgebildet den Energiespeicher 30 lösbar im Gehäuse 26 so zu fixieren, dass der Energiespeicher 30 entnehm- und wechselbar ist, insbesondere werkzeuglos.

Die Aufnahme 32 weist eine Führung 36 auf, mit welcher der Energiespeicher 30 bei der Installation in eine Steckposition geführt werden kann.

Im Ausführungsbeispiel umfasst die Führung 36 eine Führungsnut 38, in welche ein am Energiespeicher 30 vorgesehenes Führungsgegenstück 40 wie ein Zapfen eingreifen kann.

Die Aufnahme 32, insbesondere die Führung 36 ist nach dem Poka-Yoke-Prinzip ausgebildet. Der Energiespeicher 30 kann also nur in eine definierte Weise in die Aufnahme 32 eingesetzt werden, wodurch das Risiko von Fehlern bei der Installation minimiert wird.

Im Ausführungsbeispiel sind an der Aufnahme 32 sowie dem Energiespeicher 30 außerdem zueinander korrespondierende, bzw. ineinandergreifende, Arretierungselemente 42 vorgesehen, die dazu ausgebildet sind, den Energiespeicher 30 in der Steckposition lösbar zu arretieren. Der Energiespeicher 30 kann so in der Steckposition gesichert werden, beispielsweise gegen ein unbeabsichtigtes Lösen infolge von Vibrationen.

Aus der in Fig. 2 gezeigten Ausführungsvariante geht hervor, dass die Aufnahme 32 für den Energiespeicher 30 und das Fixiermittel 20 entgegengesetzten Seiten des Gehäuses 26 zugeordnet sind. Vereinfacht ausgedrückt befindet sich in Fig. 2 die Aufnahme 32 für den Energiespeicher 30 an der Oberseite, wohingegen sich das Fixiermittel 20 an der Unterseite der dargestellten USV-Baugruppe 16 befindet. Durch diesen Aufbau wird eine gute Handhabung der USV-Baugruppe 16 bei Wartungsarbeiten und/oder einem Energiespeicher- bzw. Baugruppenaustausch erreicht, da der Energiespeicher 30 leicht zugänglich ist.

Beispielsweise muss die USV-Baugruppe 16 für einen Austausch des Energiespeichers 30 nicht erst von der Basis 12 (also der Schaltschrankschiene 18) gelöst werden, da die Aufnahme 32 auch dann frei zugänglich ist, wenn die USV-Baugruppe 16 im Schaltschrank 11 installiert ist.

Insbesondere kann der Energiespeicher 30 auch während eines laufenden Betriebes der USV-Baugruppe 16 entfernt und/oder ausgetauscht werden, was als "hot swapping" bzw. "hot plugging" bezeichnet wird. Dies wird unter anderem durch eine spezielle Ausgestaltung der Aufnahme 32 erreicht, die es ermöglicht, den Energiespeicher 30 derart lösbar im oder am Gehäuse 26 zu fixieren, dass er auch beim laufenden Betrieb aus der Aufnahme 32 entfernt, bzw. in diese eingesetzt werden kann.

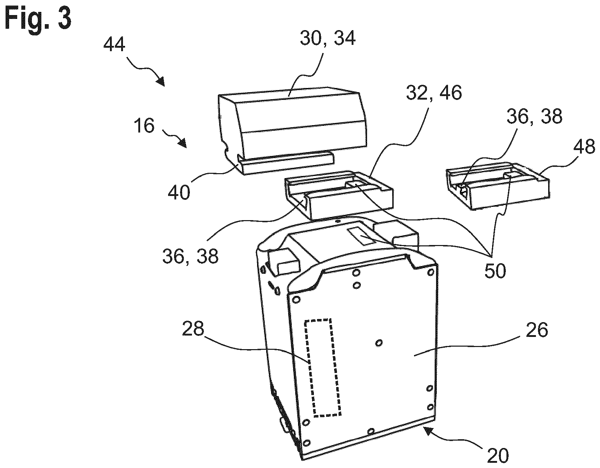

Fig. 3 zeigt eine schematische Darstellung eines Ausführungsbeispiels eines USV-Baugruppen-Bausatzes 44.

Der USV-Baugruppen-Bausatz 44 umfasst eine erfindungsgemäße USV-Baugruppe 16 einer zweiten beispielhaften Ausführungsform.

Diese entspricht im Wesentlichen der in Fig. 2 gezeigten USV-Baugruppe 16, sodass im Folgenden lediglich auf die Unterschiede eingegangen wird. Gleiche und funktionsgleiche Bauteile sind mit den gleichen Bezugszeichen versehen.

Besonders an der in Fig. 3 gezeigten USV-Baugruppe 16 ist, dass die Aufnahme 32 für den Energiespeicher 30 als austauschbarer Adapter 46 ausgebildet ist, mit dem der Energiespeicher 30 elektrisch an die USV-Elektronik 28 sowie mechanisch an das Gehäuse 26 angebunden werden kann.

Alternativ kann die Aufnahme 32 auch einen entsprechenden austauschbaren Adapter 46 umfassen, der dazu ausgebildet ist, den Energiespeicher 30 elektrisch an die USV-Elektronik 28 anzubinden und/oder mechanisch an das Gehäuse 26 anzubinden. Die Aufnahme 32 kann also auch über den Adapter 46 hinausgehende Bestandteile aufweisen, beispielsweise zusätzliche Führungs- oder Sicherungselemente.

In der in Fig. 3 dargestellten Variante der USV-Baugruppe 16 weist die Aufnahme 32 (also der Adapter 46) eine Führung 36 auf, die als C-förmige Führungsnut 38 ausgebildet ist.

Der Energiespeicher 30 umfasst ein T-förmiges Führungsgegenstück 40, welches in die Führung 36 bzw. Führungsnut 38 eingeschoben werden kann.

Die Führung 36 ist im Zusammenspiel mit dem Führungsgegenstück 40 dazu ausgebildet, den Energiespeicher 30 in der Steckposition quer sowie senkrecht zur Einschubrichtung in zwei Raumrichtungen zu fixieren. Dadurch wird der Energiespeicher 30 in der Steckposition sicher gehalten. Optional kann ein Arretierungselement vorgesehen sein, welches den Energiespeicher 30 zusätzlich in Einschubrichtung arretiert.

Neben der USV-Baugruppe 16 und dem von der USV-Baugruppe 16 umfassten Adapter 46 weist der USV-Baugruppen-Bausatz 44 zumindest einen weiteren austauschbaren Adapter 48 auf. Es sind also insgesamt zumindest zwei Adapter 46, 48 vorgesehen.

Die Adapter 46, 48 sind unterschiedlich geformt. Beispielsweise können die Adapter 46, 48 unterschiedliche Führungen 36, insbesondere verschiedene Nutgeometrien, und/oder verschiedene elektrische Anschlüsse 50 aufweisen.

Im Ausführungsbeispiel ist jeder der unterschiedlichen austauschbaren Adapter 46, 48 dazu ausgebildet, jeweils einen Energiespeicher 30 eines bestimmten Typs elektrisch an die USV-Elektronik 28 anzubinden sowie mechanisch an das Gehäuse 26 anzubinden. Dazu werden mittels der elektrischen Anschlüsse 50 der jeweiligen Adapter 46, 48 elektrische Verbindungen zwischen den jeweiligen Energiespeichern 30 und der USV-Elektronik 28 hergestellt, insbesondere durch eine Kopplung mit weiteren am Gehäuse 26 sowie den Energiespeichern 30 vorgesehenen korrespondierenden elektrischen Anschlüssen 50.

Optional kann der USV-Baugruppen-Bausatz 44 auch mehrere, insbesondere zu den Adaptern 46, 48 passende, Energiespeicher 30 unterschiedlichen Typs umfassen. Zur Vereinfachung ist in Fig. 3 nur ein Energiespeicher 30 dargestellt.

## Patentansprüche

1. USV-Baugruppe, umfassend ein Gehäuse (26), eine USV-Elektronik (28), die im Gehäuse (26) angeordnet ist, einen Energiespeicher (30) und eine Aufnahme (32) für den Energiespeicher (30), die im oder am Gehäuse (26) angeordnet ist, wobei die Aufnahme (32) für den Energiespeicher (30) dazu ausgebildet ist, den Energiespeicher (30) lösbar im oder am Gehäuse (26) zu fixieren, sodass der Energiespeicher (30) entnehm- und wechselbar ist, und wobei der Energiespeicher (30) dazu ausgebildet ist, in die Aufnahme (32) so eingesteckt zu werden oder an die Aufnahme (32) so angesteckt zu werden, dass eine elektrische Verbindung vom Energiespeicher (30) zur USV-Elektronik (28) gebildet ist.

2. USV-Baugruppe nach Anspruch 1, wobei die Aufnahme (32) dazu ausgebildet ist, den Energiespeicher (30) derart lösbar im oder am Gehäuse (26) zu fixieren, dass der Energiespeicher (30) während eines laufenden Betriebes der USV-Baugruppe (16) entfernt und/oder ausgetauscht werden kann.

3. USV-Baugruppe nach Anspruch 1 oder 2, ferner umfassend ein Fixiermittel (20), insbesondere zur mechanischen Fixierung der USV-Baugruppe (16) an einer Steckplatte oder an einer Schiene, insbesondere an einer Schaltschrankschiene (18), wobei die Aufnahme (32) für den Energiespeicher (30) und das Fixiermittel (20) auf unterschiedlichen Seiten des Gehäuses (26) angeordnet sind.

4. USV-Baugruppe nach einem der vorhergehenden Ansprüche, wobei die Aufnahme (32) für den Energiespeicher (30) zumindest eine Führung (36) zur Führung des Energiespeichers (30) in eine Steckposition aufweist, insbesondere wobei die Führung (36) eine Führungsnut (38) aufweist, sodass die zumindest eine Führung (36) dazu ausgebildet ist, den Energiespeicher (30) in der Steckposition in zumindest zwei Raumrichtungen zu fixieren, insbesondere wobei die Aufnahme (32) und/oder der Energiespeicher (30) ein Arretierungselement (42) umfasst, das dazu ausgebildet ist, den Energiespeicher (30) in der Steckposition lösbar zu arretieren, insbesondere wobei die Aufnahme (32) und der Energiespeicher (30) zueinander korrespondierende Arretierungselemente (42) umfassen.

5. USV-Baugruppe nach einem der vorhergehenden Ansprüche, wobei der Energiespeicher (30) eine Batterie ist, insbesondere ein Akku (34), der zur unmittelbaren Anbindung in oder an einem Handwerkzeug und zum Betrieb des Handwerkzeuges geeignet ist.

6. USV-Baugruppe nach einem der vorhergehenden Ansprüche, wobei die Aufnahme (32) für den Energiespeicher (30) als ein austauschbarer Adapter (46) ausgebildet ist, der dazu ausgebildet ist, den Energiespeicher (30) elektrisch an die USV-Elektronik (28) anzubinden und/oder mechanisch an das Gehäuse (26) anzubinden, oder wobei die Aufnahme (32) für den Energiespeicher (30) einen austauschbaren Adapter (46) umfasst, der dazu ausgebildet ist, den Energiespeicher (30) elektrisch an die USV-Elektronik (28) anzubinden und/oder mechanisch an das Gehäuse (26) anzubinden.

7. USV-Baugruppen-Bausatz, umfassend eine USV-Baugruppe (16) gemäß einem der vorhergehenden Ansprüche und eine Mehrzahl unterschiedlicher austauschbarer Adapter (46, 48), wobei jeder der unterschiedlichen austauschbaren Adapter (46, 48) dazu ausgebildet ist, jeweils einen Energiespeicher (30) eines bestimmten Typs elektrisch an die USV-Elektronik (28) anzubinden und/oder mechanisch an das Gehäuse (26) anzubinden.

8. Elektrische Anlage, umfassend eine USV-Baugruppe (16) gemäß einem der Ansprüche 1 bis 6 und eine Basis (12) zur Aufnahme der USV-Baugruppe (16).

9. Elektrische Anlage nach Anspruch 8, wobei ein Schaltschrank (11) vorgesehen ist, in dem die Basis (12) als Schaltschrankschiene (18) ausgebildet ist.

10. Verwendung eines Akkus (34) für Handwerkzeuge in einer USV-Baugruppe (16), insbesondere gemäß einem der Ansprüche 1 bis 6, als Energiespeicher (30) zum Bereitstellen elektrischer Energie für eine unterbrechungsfreie Stromversorgung.
